# EUROPÄISCHE PATENTSCHRIFT

(11) **EP 3 835 799 B1**
(45) Veröffentlichungstag und Bekanntmachung des Hinweises auf die Patenterteilung: **26.07.2023**
(21) Anmeldenummer: 19214848.4
(22) Anmeldetag: 10.12.2019
(51) Int. Cl.: G01R 31/327

(54) **SCHALTUNGSEINRICHTUNG FÜR SICHERHEITSANWENDUNGEN**
CIRCUIT DEVICE FOR SECURITY APPLICATIONS
AGENCEMENT DE CIRCUIT POUR APPLICATIONS DE SÉCURITÉ

(43) Veröffentlichungstag der Anmeldung: 16.06.2021
(73) Patentinhaber: Schneider Electric Industries SAS, 92500 Rueil Malmaison (FR)
(72) Erfinder: Geoffroy, Guillaume, 77955 Ettenheim (DE); Kloeser, Frank, 77749 Hohberg (DE)
(74) Vertreter: Manitz Finsterwald Patent- und Rechtsanwaltspartnerschaft mbB

(56) Entgegenhaltungen:
- EP-A1- 2 883 068
- DE-A1- 19 532 633
- DE-A1-102012 004 843
- US-A1- 2006 212 745

## Beschreibung

Die vorliegende Erfindung betrifft eine Schaltungseinrichtung für Sicherheitsanwendungen, welche zum Schalten einer elektrischen Last ausgebildet ist.

Aus der US 2006/212745 A1 ist ein Verfahren zum Erfassen des Schaltzustands eines einzelnen Schaltelements einer Schaltungseinrichtung bekannt. Hierzu wird mittels eines Signalgenerators ein Signal mit einer speziellen Frequenz dem Schaltelement zugeführt. Dem Schaltelement nachgelagert ist ein Detektor vorgesehen, welcher die spezielle Frequenz herausfiltert und somit erfasst, ob das Signal durch das Schaltelement durchgeleitet wurde.

Schaltungseinrichtungen für Sicherheitsanwendungen erfordern üblicherweise einen hohen Aufwand, da ein Ausschalten (d.h. ein Durchtrennen eines Stromkreises) zuverlässig von der Schaltungseinrichtung durchgeführt werden muss. Hierfür ist es bekannt, zwangsgeführte Relais einzusetzen, welche allerdings einen hohen Herstellungsaufwand und dementsprechend hohe Kosten verursachen.

Es ist daher die der Erfindung zugrundeliegende Aufgabe, eine Schaltungsanordnung anzugeben, welche mit geringen Kosten herstellbar ist und trotzdem für Sicherheitsanwendungen nutzbar ist.

Diese Aufgabe wird durch eine Schaltungseinrichtung gemäß Anspruch 1 gelöst.

Die erfindungsgemäße Schaltungseinrichtung weist zumindest zwei in Reihe geschaltete Schaltelemente auf und umfasst ferner eine Überprüfungseinrichtung, welche den tatsächlichen Schaltzustand der Schaltelemente überwacht. Die Überprüfungseinrichtung weist einen Signalgenerator zur Abgabe eines Testsignals an die Schaltelemente auf, wobei die Überprüfungseinrichtung ein erstes Signalveränderungselement, welches elektrisch mit dem ersten Schaltelement gekoppelt ist, und ein zweites Signalveränderungselement, welches elektrisch mit dem zweiten Schaltelement gekoppelt ist, umfasst. Dabei verändern das erste und zweite Signalveränderungselement ein jeweils eingehendes Testsignal auf unterschiedliche Weise und erzeugen durch die Veränderung ein erstes und zweites Prüfsignal, wobei ein Signalempfänger das erste und/oder zweite Prüfsignal empfängt.

Kurz gesagt, wird also durch den Signalgenerator ein Testsignal an die Schaltelemente übertragen, wobei bei geschlossenen, d.h. leitenden, Schaltelementen das Testsignal dann an die Signalveränderungselemente übertragen wird, wobei die Signalveränderungselemente das Testsignal jeweils auf eine eigene charakteristische Weise verändern und somit das erste und zweite Prüfsignal erzeugen. Wird nun das erste und/oder zweite Prüfsignal von dem Signalempfänger erkannt, kann rückgeschlossen werden, dass das erste und/oder zweite Schaltelement geschlossen sind. Wird das jeweilige Prüfsignal nicht empfangen, so bedeutet dies, dass das jeweilige Schaltelement geöffnet, d.h. nicht-leitend, ist. Der Schaltzustand der Schaltelemente kann auf diese Weise sicher detektiert werden, wodurch keine zwangsgeführten Relais, sondern beispielsweise Standard-Relais in der Schaltungseinrichtung eingesetzt werden. Hierdurch können die Kosten und der Aufwand für die Schaltungsanordnung deutlich reduziert werden. Nichtsdestotrotz ist die Schaltungsanordnung aufgrund der eindeutigen Erkennung des Schaltzustands der Schaltelemente in Sicherheitsanwendungen einsetzbar.

Sicherheitsanwendungen, beispielsweise nach dem Standard SIL2 oder SIL3 (Safety Integrity Level) sind insbesondere dort vorgeschrieben, wo die Gefahr der Verletzung von Personen besteht, beispielsweise bei automatisierten Fertigungsanlagen. Für Sicherheitsanwendungen ist dementsprechend üblicherweise eine Redundanz vorgeschrieben, so dass beispielsweise ein Roboter nicht aufgrund eines einfachen Fehlers wieder anlaufen und einen Menschen verletzen kann.

Das Abschalten der Last kann die Schaltungsanordnung dadurch bewirken, dass zumindest eines der Schaltelemente (üblicherweise aber alle Schaltelemente) nicht-leitend geschaltet wird. Die beiden Schaltelemente können bevorzugt zwischen einem ersten und einem zweiten Schaltanschluss in Reihe geschaltet werden, wobei beispielsweise an den ersten Schaltanschluss eine Versorgungsspannung und an den zweiten Schaltanschluss ein Eingang einer Last angeschlossen werden kann.

Die hierin beschriebene Schaltungseinrichtung kann bevorzugt in einem einzigen Gehäuse angeordnet sein.

Weiterbildungen der Erfindung sind der Beschreibung, den Zeichnungen sowie den Unteransprüchen zu entnehmen.

Erfindungsgemäß erzeugt das erste Signalveränderungselement durch eine erste Phasenverschiebung aus dem Testsignal das erste Prüfsignal. Weiter erfindungsgemäß erzeugt das zweite Signalveränderungselement durch eine zweite Phasenverschiebung, welche sich von der ersten Phasenverschiebung unterscheidet, aus dem Testsignal das zweite Prüfsignal. Bei der Signalveränderung durch eine Phasenverschiebung ist von Vorteil, dass die Phasenverschiebung mit technisch relativ einfachen Mitteln erfolgen kann. Beispielsweise kann die Phasenverschiebung durch einen Allpass und/oder einen aktiven Bandpass oder Tiefpass erfolgen.

Zudem kann das jeweilige Signalveränderungselement durch die Phasenverschiebung oder zusammen mit der Phasenverschiebung eine Bandpassfilterung bewirken. Hierdurch kann beispielsweise Netzrauschen nur vermindert oder gar nicht an den Signalempfänger durchgeleitet werden. Die Bandpassfilterung kann beispielsweise eine Bandbreite von 300 kHz aufweisen.

Bei der Erzeugung einer Phasenverschiebung ist es zudem auf einfache Weise möglich, die Veränderung des Testsignals zu detektieren. Beispielsweise kann das erste Prüfsignal gegenüber dem Testsignal um 80° und das zweite Prüfsignal um 170° gegenüber dem Testsignal verschoben sein. Wird also ein um 80° verschobenes Testsignal erkannt, ist das erste Schaltelement geschlossen, wohingegen beim Erkennen eines um 170° verschobenen Prüfsignals das zweite Schaltelement geschlossen ist.

Es versteht sich, dass neben den genannten Phasenverschiebungen auch andere Phasenverschiebungen möglich sind, solange die Phasenverschiebung zwischen dem ersten Prüfsignal und dem zweiten Prüfsignal ausreichend groß ist. Bevorzugt liegt die Phasenverschiebung zwischen dem ersten Prüfsignal und dem zweiten Prüfsignal in einem Bereich zwischen 90° und 270°.

Alternativ oder zusätzlich können die Signalveränderungselemente das Testsignal auch auf andere Weise verändern, beispielsweise durch eine Veränderung der Amplitude des Testsignals, durch eine Veränderung der Frequenz des Testsignals und/oder durch Einfügen von zusätzlichen Signalteilen, beispielsweise von zusätzlichen Bits bei einem digitalen Signal.

Das Testsignal kann insbesondere dauerhaft erzeugt werden. Alternativ kann das Testsignal auch nur wiederholt, d.h. gepulst, oder nur dann erzeugt werden, wenn die Schaltungseinrichtung ein Schaltsignal zur Veränderung des Schaltzustands der Schaltelemente erhalten hat.

Gemäß einer weiteren Ausführungsform werden einerseits das Testsignal und das erste Prüfsignal und/oder andererseits das Testsignal und das zweite Prüfsignal jeweils einem Exklusiv-Oder-Gatter (XOR) zugeführt, um eine Phasenverschiebung zwischen dem Testsignal und dem ersten und/oder zweiten Prüfsignal zu ermitteln. Vor dem Zuführen zu dem XOR-Gatter kann das Testsignal und/oder das jeweilige Prüfsignal einem Komparator zugeführt werden, wodurch eine Digitalisierung erfolgt. Sind das Testsignal und das jeweilige Prüfsignal nicht phasenversetzt, sind die Signale jeweils (bei geschlossenem Schaltelement und insbesondere nach dem Digitalisieren) gleich, was dazu führt, dass der Ausgang des XOR-Gatters jeweils Null ist. Bei einem Phasenversatz unterscheiden sich die beiden Eingangssignale (d.h. Testsignal und Prüfsignal) des XOR-Gatters jeweils für einen bestimmten Zeitabschnitt, wobei das Ausgangssignal des XOR-Gatters in diesem Zeitabschnitt dann Eins ist. Die Erfassung, ob das Ausgangssignal zu einem Zeitpunkt Null oder Eins ist, kann auf einfache Art und Weise mittels einer "Timer Capture"-Funktion eines Mikrocontrollers vorgenommen werden, wodurch die Erfassung des zeitlichen Versatzes und damit des Phasenversatzes schnell und mit geringem Aufwand ermöglicht wird.

Gemäß einer weiteren Ausführungsform wird das Testsignal sowohl dem ersten als auch dem zweiten Schaltelement zugeführt, wobei das Testsignal von dem ersten Schaltelement an das erste Signalveränderungselement und/oder von dem zweiten Schaltelement an das zweite Signalveränderungselement übertragen wird, wenn das jeweilige Schaltelement leitend ist. Die Zuführung des Testsignals bzw. die Einkopplung des Testsignals kann also beispielsweise an einer Verbindungsleitung zwischen den beiden Schaltelementen erfolgen. Es liegt dementsprechend einerseits eine Reihenschaltung von Signalgenerator, erstem Schaltelement und erstem Signalveränderungselement und andererseits von Signalgenerator, zweitem Schaltelement und zweiten Signalveränderungselement vor. Die Signalveränderungselemente sind dementsprechend dem jeweiligen Schaltelement nachgeschaltet.

Im offenen, d.h. nicht-leitenden, Zustand des jeweiligen Schaltelements wird das Testsignal demnach nicht an die Signalveränderungselemente weitergeleitet oder das Testsignal wird so stark gedämpft, dass der offene Zustand des Schaltelements klar ersichtlich ist. Insbesondere werden Prüfsignale nur dann berücksichtigt, wenn deren Stärke oder Amplitude über einem vorbestimmten Schwellenwert liegt. Hierzu kann beispielsweise der Komparator entsprechend ausgebildet sein, so dass Prüfsignale unter dem Schwellenwert z.B. auf den Wert Null abgebildet werden.

Gemäß einer weiteren Ausführungsform umfasst das Testsignal eine sinusförmige Komponente, welche bevorzugt eine Frequenz von größer 50 kHz, insbesondere eine Frequenz zwischen 50 und 300 kHz, aufweist. Durch die sinusförmige Komponente kann die Phasenverschiebung besonders einfach erzeugt und auch detektiert werden.

Bevorzugt kann das Testsignal auch mehrere Frequenzen, d.h. sinusförmige Komponenten, umfassen, wodurch die Schaltungseinrichtung und insbesondere die Erkennung des Schaltzustands der Schaltelemente, robuster gegen Netzschwingungen und Rauscheinflüsse von außen werden. Die verschiedenen Frequenzen können dabei jeweils derselben oder auch einer frequenzabhängigen Phasenverschiebung unterliegen. Hierbei ist lediglich von Bedeutung, dass die Veränderung einer jeweiligen Frequenz eindeutig dem ersten oder zweiten Signalveränderungsmittel zugeordnet werden kann.

Gemäß einer weiteren Ausführungsform umfassen der Signalgenerator und/oder der Signalempfänger denselben Mikrocontroller. Anders ausgedrückt bildet ein einziger Mikrocontroller den Signalgenerator und/oder den Signalempfänger. In dem Mikrocontroller kann dann auch insbesondere das XOR-Gatter implementiert sein, wobei der Mikrocontroller dem XOR-Gatter das von dem Mikrocontroller selbst erzeugte Testsignal und auch das vom Mikrocontroller empfangene Prüfsignal zuführt. Auf diese Weise kann der Mikrocontroller eine sehr schnelle und genaue Ermittlung der Phasenverschiebung des Prüfsignals relativ zu dem Testsignal durchführen.

Insbesondere sind in dem Mikrocontroller zumindest zwei XOR-Gatter implementiert, eines zur Ermittlung des Phasenversatzes des ersten Prüfsignals und ein zweites zur Ermittlung des Phasenversatzes des zweiten Prüfsignals.

Gemäß einer weiteren Ausführungsform sind der Signalgenerator und/oder der Signalempfänger, insbesondere jeweils, mittels eines Koppelkondensators elektrisch mit den Schaltelementen verbunden, um eine kapazitive Isolation zu bewirken. Durch den Koppelkondensator werden der Signalgenerator und der Signalempfänger vom Potential der Schaltanschlüsse abgekoppelt, so dass mittels der Schaltanschlüsse hohe Spannungen um Ströme geschaltet werden können, ohne den Signalgenerator und/oder den Signalempfänger zu beeinflussen. Die Detektion des Schaltzustands der Schaltelemente wird auf diese Weise unabhängig vom Strom durch die Schaltelemente.

Gemäß einer weiteren Ausführungsform umfasst der Signalgenerator einen Schwingkreis, insbesondere einen LC-Schwingkreis, und/oder einen Bandpass. Durch den Schwingkreis kann sichergestellt werden, dass das Testsignal immer mindestens einen vordefinierten Pegel aufweist und/oder zumindest einen vordefinierten Strom besitzt, beispielsweise 100 mA. Durch den Bandpass kann aus einem Rechtecksignal des Mikrocontrollers ein sinusförmiges Signal geformt werden, wodurch eine aufwendige Herstellung eines sinusförmigen Signals durch den Mikrocontroller eingespart werden kann. Insbesondere kann eine Reihenschaltung vorliegen, bei welcher ein Ausgang des Mikrocontrollers, welcher das Testsignal (oder genauer gesagt ein rechteckförmiges Signal) erzeugt, der Bandpass, der Schwingkreis und der Koppelkondensator in Reihe geschalten sind. Insbesondere umfasst die Reihenschaltung genau die vorgenannte Reihenfolge.

Es versteht sich, dass das vom Mikrocontroller erzeugte Rechtecksignal bereits als Testsignal angesehen und/oder auch als solches verwendet werden kann.

Gemäß einer weiteren Ausführungsform ist die Überprüfungseinrichtung ausgebildet, zumindest aus dem ersten und/oder dem zweiten Funksignal eine Schaltzeit zu ermitteln, die das erste und/oder das zweite Schaltelement benötigt, um von einem leitenden Zustand in einen nicht-leitenden Zustand zu schalten. Die Überprüfungseinrichtung kann auch die Schaltzeit ermitteln, die zum Schalten von einem nicht-leitenden Zustand in einen leitenden Zustand benötigt wird. Die Schaltzeit wird insbesondere derart ermittelt, dass ein Schaltsignal, welches eine Veränderung des Schaltzustands eines oder mehrerer Schaltelemente bewirkt, detektiert wird. Zusätzlich wird ermittelt, wann ein leitender oder nicht-leitender Zustand der Schaltelemente vorliegt, wobei diese Ermittlung mittels des Prüfsignals erfolgt. Die Zeitdauer zwischen dem Vorliegen des Schaltsignals und der Änderung des Schaltzustands ist dann die Schaltzeit.

Gemäß einer weiteren Ausführungsform ist die Überprüfungseinrichtung ausgebildet, ein Warnsignal auszugeben, wenn die Schaltzeit einen vorbestimmten Schwellenwert überschreitet. Eine zu lange Schaltzeit deutet beispielsweise auf einen Verschleiß der Schaltelemente hin. Auf das Warnsignal hin kann dann insbesondere eine Wartung ausgelöst werden ("predictive maintenance"), bevor ein tatsächlicher Ausfall der Schaltungseinrichtung erfolgt.

Gemäß einer weiteren Ausführungsform sind die Schaltelemente mechanisch voneinander entkoppelt und insbesondere nicht zwangsgeführt. Die Schaltelemente können zudem (reine) Kupfer-Kontakte, insbesondere ohne Vergoldung, aufweisen. Wie oben bereits angedeutet, können aufgrund der robusten Erkennung des Schaltzustands beispielsweise Standard-Relais als Schaltelemente eingesetzt werden, wobei die Standard-Relais eigentlich nicht für Sicherheitsanwendungen gedacht sind. Zudem ist keine mechanische Zwangsführung und auch keine Kopplung der Relais bzw. Schaltelemente untereinander notwendig, so dass die Kosten für die Schaltungseinrichtung stark gesenkt werden können.

Gemäß einer weiteren Ausführungsform sind der Signalgenerator und/oder der Signalempfänger redundant ausgebildet. Beispielsweise können zwei Mikrocontroller vorgesehen sein, die die Redundanz bereitstellen. Jeder Mikrocontroller kann dementsprechend einen Signalgenerator und einen Signalempfänger bilden. Jeder der Signalempfänger kann dabei sowohl das erste Prüfsignal als auch das zweite Prüfsignal (oder jedes weitere Prüfsignal) empfangen. Im hier beschriebenen Beispiel können die beiden Signalempfänger folglich vier Empfangskanäle aufweisen.

Die Redundanz ermöglicht es insbesondere, die Schaltungseinrichtung für Sicherheitsanwendungen einzusetzen. Bevorzugt kann die Schaltungseinrichtung den Anforderungen gemäß SIL2 oder SIL3 entsprechen.

Weiterer Gegenstand der Erfindung ist ein Verfahren gemäß Anspruch 15. Zu dem erfindungsgemäßen Verfahren gelten die Ausführungen zu der Schaltungseinrichtung entsprechend, dies gilt insbesondere für Vorteile und bevorzugte Ausführungsformen.

Weiterhin betrifft die Erfindung eine andere Ausführungsform einer Schaltungseinrichtung insbesondere für Sicherheitseinwendungen, welche zum Schalten einer elektronischen Last ausgebildet ist, wobei die Schaltungseinrichtung zumindest ein oder nur genau ein Schaltelement umfasst und ferner eine Überprüfungseinrichtung aufweist, welche den tatsächlichen Schaltzustand des Schaltelements überwacht, wobei die Überprüfungseinrichtung einen Signalgenerator zur Abgabe eines Testsignals an das Schaltelement aufweist, wobei die Überprüfungseinrichtung ein Signalveränderungselement aufweist, welches elektrisch mit dem Schaltelement gekoppelt ist, wobei das Signalveränderungselement ein jeweils eingehendes Testsignal mittels einer Phasenverschiebung verändert, wobei ein Signalempfänger das Prüfsignal empfängt.

Auch zu der anderen Ausführungsform der Schaltungseinrichtung gelten die Ausführungen zu der erstgenannten Schaltungseinrichtung entsprechend, dies gilt insbesondere für Vorteile und bevorzugte Ausführungsformen.

Nachfolgend wird die Erfindung rein beispielhaft unter Bezugnahme auf die Zeichnungen beschrieben. Es zeigen:
- Fig. 1: eine Schaltungseinrichtung, welche zum Schalten eines elektrischen Verbrauchers dient;
- Fig. 2: eine Schaltungseinrichtung in detaillierter Darstellung; und
- Fig. 3: ein Test- und ein Prüfsignal in einer Schaltungseinrichtung.

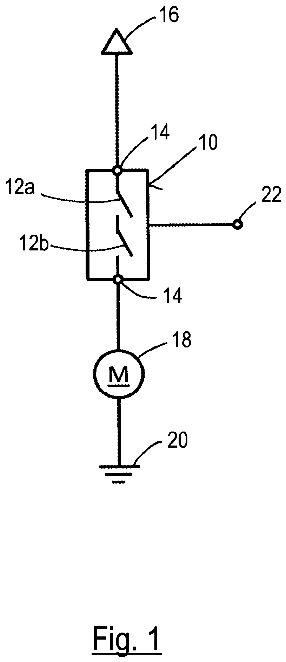

Fig. 1 zeigt eine Schaltungseinrichtung 10, welche zwei in Reihe geschaltete Schaltelemente in der Form von Relais 12a, 12b aufweist. Die Relais 12 sind zwischen zwei Schaltanschlüsse 14 der Schaltungseinrichtung 10 geschaltet. Einer der Schaltanschlüsse 14 ist mit einer Versorgungsspannung 16 und der andere der Schaltanschlüsse 14 ist mit einem Motor 18, d.h. mit einer elektrischen Last, gekoppelt. Der Motor 18 selbst ist wieder mit Masse 20 verbunden.

Der Schaltungseinrichtung 10 ist zudem ein Schaltsignal 22 zugeführt, welches entweder ein Durchschalten der Versorgungsspannung 16 an den Motor 18 oder ein Trennen der Versorgungsspannung 16 vom Motor 18 bewirkt.

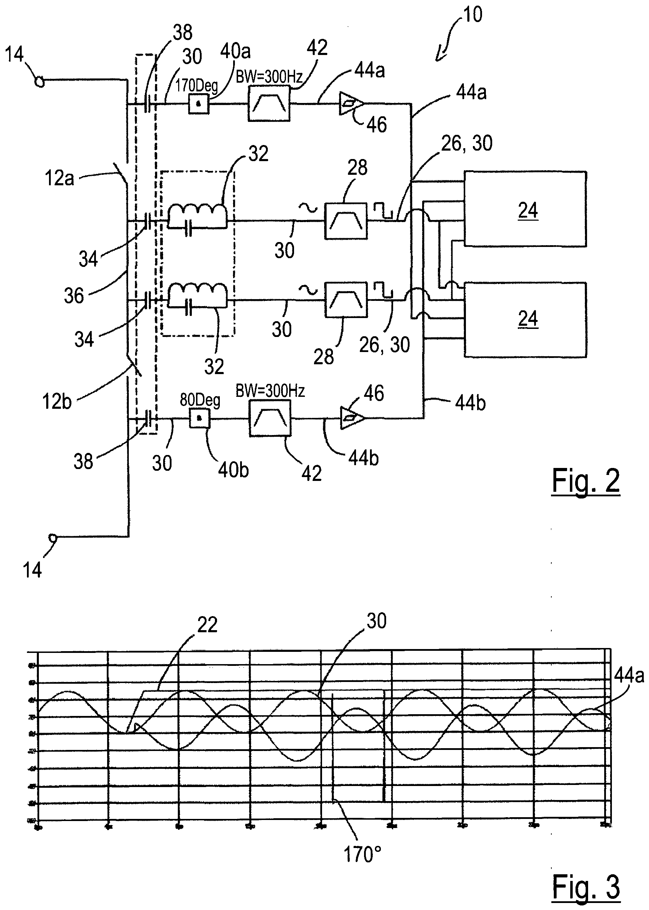

Die Schaltungseinrichtung 10 ist in Fig. 2 genauer dargestellt. Aus Fig. 2 ist ersichtlich, dass die Schaltungseinrichtung 10 zwei Mikrocontroller 24 umfasst, welche redundant ausgelegt sind. Jeder Mikrocontroller 24 umfasst einen Ausgang, welcher ein Rechtecksignal 26 liefert, welches bereits als Testsignal 30 verstanden werden kann. Das Rechtecksignal 26 wird einem ersten Bandpass 28 zugeführt, wobei der erste Bandpass 28 das ursprüngliche Testsignal 30 in ein etwa sinusförmiges Testsignal 30 umwandelt.

Das Testsignal 30 wird jeweils einem LC-Schwingkreis 32 zugeführt, wobei die Resonanzfrequenz des LC-Schwingkreises 32 bevorzugt der Frequenz des Testsignals 30 entspricht. Der LC-Schwingkreis 32 verstärkt das Testsignal 30 und leitet es an einen ersten Koppelkondensator 34 weiter. Der erste Koppelkondensator 34 koppelt das Testsignal 30 in eine Verbindungsleitung 36 ein, welche die Relais 12 miteinander verbindet.

In entsprechender Weise kann auch der zweite Mikrocontroller 24 dasselbe Testsignal 30 in die Verbindungsleitung 36 einkoppeln.

Bei geschlossenen Relais 12a, 12b wird das Testsignal an zweite Koppelkondensatoren 38 übertragen, wobei die zweiten Koppelkondensatoren 38 jeweils mit einem Phasenschieber 40a, 40b verbunden sind. Der Phasenschieber 40a bewirkt eine Phasenverschiebung von 170°, wohingegen der Phasenschieber 40b eine Phasenverschiebung um 80° erzeugt. Die Phasenschieber 40a, 40b entsprechen dem ersten und zweiten Signalveränderungselement.

Das Signalveränderungselement kann auch einen zweiten Bandpass 42 umfassen, welcher im vorliegenden Beispiel dem Phasenschieber 40a, 40b nachgeschaltet ist. Der zweite Bandpass 42 kann eine Bandbreite von 300 kHz aufweisen.

Der jeweilige Phasenschieber 40a, 40b zusammen mit dem zweiten Bandpass 42 erzeugt ein erstes bzw. zweites Prüfsignal 44a, 44b. Das jeweilige Prüfsignal 44a, 44b wird anschließend noch von einem Komparator 46 digitalisiert.

Das digitalisierte Prüfsignal 44a, 44b wird schließlich jeweils einem (nicht gezeigten) Signalempfänger beider Mikrocontroller 24 zugeführt. In dem Mikrocontroller ist ein (ebenfalls nicht dargestelltes) XOR-Gatter vorgesehen, dem das Rechtecksignal 26 (und damit das Testsignal 30) und auch eines der Prüfsignale 44a, 44b zugeführt wird.

Der Mikrocontroller 24 kann mittels des XOR-Gatters eine jeweilige Phasenverschiebung zwischen dem Rechtecksignal 26 und dem Prüfsignal 44a, 44b feststellen. Aus der Phasenverschiebung kann der Mikrocontroller 24 dann ermitteln, welches der Relais 12 geschlossen oder offen ist.

Ein Diagramm von Signalen ist in Fig. 3 gezeigt, wobei auf der x-Achse die Zeit aufgetragen ist. Es ist zu erkennen, dass das Testsignal 30 durchgängig eine sinusförmige Gestalt aufweist. Nach dem Einschalten des Schaltsignals 22 werden die beiden Relais 12 geschlossen, wobei hierdurch Prüfsignale 44a, 44b entstehen. Von den Prüfsignalen 44a, 44b ist in Fig. 3 lediglich das Prüfsignal 44a gezeigt. Wie aus Fig. 3 ersichtlich ist, besteht ein Phasenversatz von etwa 170° zwischen dem Prüfsignal 44a und dem Testsignal 30. Der Mikrocontroller 24 kann somit auf einfache aber zuverlässige Weise feststellen, dass das Relais 12a geschlossen ist.

### Bezugszeichenliste

- 10: Schaltungseinrichtung
- 12: Relais
- 14: Schaltanschluss
- 16: Versorgungsspannung
- 18: Motor
- 20: Masse
- 22: Schaltsignal
- 24: Mikrocontroller
- 26: Rechteck-Signal
- 28: erster Bandpass
- 30: Testsignal
- 32: LC-Schwingkreis
- 34: erster Koppelkondensator
- 36: Verbindungsleitung
- 38: zweiter Koppelkondensator
- 40: Phasenschieber
- 42: zweiter Bandpass
- 44: Prüfsignal
- 46: Komparator

## Patentansprüche

1. Schaltungseinrichtung (10) für Sicherheitsanwendungen, welche zum Schalten einer elektrischen Last (18) ausgebildet ist,
**dadurch gekennzeichnet, dass** die Schaltungseinrichtung (10) zumindest zwei in Reihe geschaltete Schaltelemente (12a, 12b) umfasst und ferner eine Überprüfungseinrichtung (24) aufweist, welche den tatsächlichen Schaltzustand der Schaltelemente (12a, 12b) überwacht,
wobei die Überprüfungseinrichtung (24) einen Signalgenerator zur Abgabe eines Testsignals (30) an die Schaltelemente (12a, 12b) aufweist,
wobei die Überprüfungseinrichtung ein erstes Signalveränderungselement (40a), welches elektrisch mit dem ersten Schaltelement (12a) gekoppelt ist, und ein zweites Signalveränderungselement (40b), welches elektrisch mit dem zweiten Schaltelement (12b) gekoppelt ist, umfasst,
wobei bei geschlossenen, d.h. leitenden, Schaltelementen (12a, 12b) das Testsignal an die Signalveränderungselemente (40a, 40b) übertragen wird, wobei das erste und zweite Signalveränderungselement (40a, 40b) ein jeweils eingehendes Testsignal (30) auf unterschiedliche Weise verändern und durch die Veränderung ein erstes und zweites Prüfsignal (44a, 44b) erzeugen, wobei ein Signalempfänger das erste und/oder zweite Prüfsignal (44a, 44b) empfängt, und
wobei das erste Signalveränderungselement (40a) durch eine erste Phasenverschiebung aus dem Testsignal (30) das erste Prüfsignal (44a) erzeugt
und
das zweite Signalveränderungselement (40b) durch eine zweite Phasenverschiebung, welche sich von der ersten Phasenverschiebung unterscheidet, aus dem Testsignal (30) das zweite Prüfsignal (44b) erzeugt.

2. Schaltungseinrichtung (10) nach Anspruch 1,
wobei das Testsignal (30) und das erste Prüfsignal (44a) und/oder das Testsignal (30) und das zweite Prüfsignal (44b) jeweils einem Exklusiv-Oder-Gatter, XOR, zugeführt werden, um eine Phasenverschiebung zwischen dem Testsignal (30) und dem ersten und/oder zweiten Prüfsignal (40a, 40b) zu ermitteln.

3. Schaltungseinrichtung (10) nach einem der vorstehenden Ansprüche,
wobei das Testsignal (30) sowohl dem ersten als auch dem zweiten Schaltelement (12a, 12b) zugeführt wird, wobei das Testsignal (30) von dem ersten Schaltelement (12a) an das erste Signalveränderungselement (40a) und/oder von dem zweiten Schaltelement (12b) an das zweite Signalveränderungselement (40b) übertragen wird, wenn das jeweilige Schaltelement (12a, 12b) leitend ist.

4. Schaltungseinrichtung (10) nach einem der vorstehenden Ansprüche,
wobei das Testsignal (30) eine sinusförmige Komponente umfasst, welche bevorzugt eine Frequenz von größer 50 kHz, insbesondere eine Frequenz zwischen 50 und 300 kHz, aufweist.

5. Schaltungseinrichtung (10) nach Anspruch 4,
wobei die sinusförmige Komponente eine Frequenz zwischen 50 und 300 kHz aufweist.

6. Schaltungseinrichtung (10) nach einem der vorstehenden Ansprüche, wobei der Signalgenerator und/oder der Signalempfänger denselben Mikrocontroller (24) umfassen.

7. Schaltungseinrichtung (10) nach einem der vorstehenden Ansprüche, wobei der Signalgenerator und/oder der Signalempfänger (jeweils) mittels eines Koppelkondensators (34, 38) elektrisch mit den Schaltelementen (12a, 12b) verbunden sind, um eine kapazitive Isolation zu bewirken.

8. Schaltungseinrichtung (10) nach einem der vorstehenden Ansprüche, wobei der Signalgenerator einen Schwingkreis (32), insbesondere einen LC-Schwingkreis, und/oder einen Bandpass (28) umfasst.

9. Schaltungseinrichtung (10) nach Anspruch 8,
wobei der Schwingkreis (32) einen LC-Schwingkreis umfasst.

10. Schaltungseinrichtung (10) nach einem der vorstehenden Ansprüche,
wobei die Überprüfungseinrichtung (24) ausgebildet ist, zumindest aus dem ersten und/oder dem zweiten Prüfsignal (44a, 44b) eine Schaltzeit zu ermitteln, die das erste und/oder das zweite Schaltelement (12a, 12b) benötigt, um von einem leitenden Zustand in einen nicht-leitenden Zustand zu schalten, oder umgekehrt.

11. Schaltungseinrichtung (10) nach Anspruch 10,
wobei die Überprüfungseinrichtung (24) ausgebildet ist, ein Warnsignal auszugeben, wenn die Schaltzeit einen vorbestimmten Schwellenwert überschreitet.

12. Schaltungseinrichtung (10) nach einem der vorstehenden Ansprüche, wobei die Schaltelemente (12a, 12b) mechanisch voneinander entkoppelt sind und insbesondere nicht zwangsgeführt sind.

13. Schaltungseinrichtung (10) nach Anspruch 12,
wobei die Schaltelemente (12a, 12b) nicht zwangsgeführt sind.

14. Schaltungseinrichtung (10) nach einem der vorstehenden Ansprüche, wobei der Signalgenerator und/oder der Signalempfänger redundant ausgebildet sind.

15. Verfahren zum Erfassen des Schaltzustands von Schaltelementen (12a, 12b) in einer Schaltungseinrichtung (10) für Sicherheitsanwendungen, wobei die Schaltungseinrichtung (10) zum Schalten einer elektrischen Last (18) ausgebildet ist,
**dadurch gekennzeichnet, dass** die Schaltungseinrichtung (10) zumindest zwei in Reihe geschaltete Schaltelemente (12a, 12b) umfasst und ferner eine Überprüfungseinrichtung aufweist, wobei die Überprüfungseinrichtung (24) ein Testsignal (30) an die Schaltelemente (12a, 12b) abgibt,
wobei bei geschlossenen, d.h. leitenden, Schaltelementen (12a, 12b) das Testsignal an die Signalveränderungselemente (40a, 40b) übertragen wird, wobei das Testsignal (30) von einem ersten und zweiten Signalveränderungselement (40a, 40b) jeweils auf unterschiedliche Weise verändert wird und durch die Veränderung ein erstes und zweites Prüfsignal (44a, 44b) erzeugt wird, wobei ein Signalempfänger das erste und/oder zweite Prüfsignal (44a, 44b) empfängt, und
wobei das erste Signalveränderungselement (40a) durch eine erste Phasenverschiebung aus dem Testsignal (30) das erste Prüfsignal (44a) erzeugt
und
das zweite Signalveränderungselement (40b) durch eine zweite Phasenverschiebung, welche sich von der ersten Phasenverschiebung unterscheidet, aus dem Testsignal (30) das zweite Prüfsignal (44b) erzeugt.

## Claims

1. A circuit device (10) for safety applications that is configured to switch an electrical load (18),
**characterized in that** the circuit device (10) comprises at least two switching elements (12a, 12b) connected in series and further has a checking device (24) which monitors the actual switching state of the switching elements (12a, 12b),
wherein the checking device (24) has a signal generator for outputting a test signal (30) to the switching elements (12a, 12b),
wherein the checking device comprises a first signal changing element (40a), which is electrically coupled to the first switching element (12a), and a second signal changing element (40b) which is electrically coupled to the second switching element (12b),
wherein, when the switching elements (12a, 12b) are closed, i.e. conductive, the test signal is transmitted to the signal changing elements (40a, 40b),
wherein the first and second signal changing element (40a, 40b) change a respective incoming test signal (30) in different ways and generate a first and second check signal (44a, 44b) by the change, wherein a signal receiver receives the first and/or second check signal (44a, 44b), and wherein the first signal changing element (40a) generates the first check signal (44a) from the test signal (30) by a first phase shift
and
the second signal changing element (40b) generates the second check signal (44b) from the test signal (30) by a second phase shift which is different from the first phase shift.

2. A circuit device (10) in accordance with claim 1,
wherein the test signal (30) and the first check signal (44a) and/or the test signal (30) and the second check signal (44b) are each supplied to an exclusive-OR gate, XOR, to determine a phase shift between the test signal (30) and the first and/or second check signal (44a, 44b).

3. A circuit device (10) in accordance with one of the preceding claims,
wherein the test signal (30) is supplied to both the first and the second switching element (12a, 12b), wherein the test signal (30) is transmitted from the first switching element (12a) to the first signal changing element (40a) and/or from the second switching element (12b) to the second signal changing element (40b) if the respective switching element (12a, 12b) is conductive.

4. A circuit device (10) in accordance with any one of the preceding claims, wherein the test signal (30) comprises a sinusoidal component which preferably has a frequency of greater than 50 kHz, in particular a frequency between 50 and 300 kHz.

5. A circuit device (10) in accordance with claim 4,
where the sinusoidal component has a frequency between 50 and 300 kHz.

6. A circuit device (10) in accordance with any one of the preceding claims, wherein the signal generator and/or the signal receiver comprises/comprise the same microcontroller (24).

7. A circuit device (10) in accordance with any one of the preceding claims, wherein the signal generator and/or the signal receiver is/are (each) electrically connected to the switching elements (12a, 12b) by means of a coupling capacitor (34, 38) to effect a capacitive isolation.

8. A circuit device (10) in accordance with any one of the preceding claims, wherein the signal generator comprises a resonant circuit (32), in particular an LC resonant circuit, and/or a bandpass (28).

9. A circuit device (10) in accordance with claim 8,
wherein the resonant circuit (32) comprises an LC resonant circuit.

10. A circuit device (10) in accordance with any one of the preceding claims, wherein the checking device (24) is configured to determine, at least from the first and/or the second check signal (44a, 44b), a switching time which the first and/or the second switching element (12a, 12b) requires/require in order to switch from a conductive state to a non-conductive state, or vice versa.

11. A circuit device (10) in accordance with claim 10,
wherein the checking device (24) is configured to output a warning signal if the switching time exceeds a predetermined threshold value.

12. A circuit device (10) in accordance with any one of the preceding claims, wherein the switching elements (12a, 12b) are mechanically decoupled from one another and are in particular not compulsorily guided.

13. A circuit device (10) in accordance with claim 12,
wherein the switching elements (12a, 12b) are not compulsorily guided.

14. A circuit device (10) in accordance with any one of the preceding claims, wherein the signal generator and/or the signal receiver is/are redundant.

15. A method of detecting the switching state of switching elements (12a, 12b) in a circuit device (10) for safety applications, wherein the circuit device (10) is configured to switch an electrical load (18),
**characterized in that** the circuit device (10) comprises at least two switching elements (12a, 12b) connected in series and further has a checking device, wherein the checking device (24) outputs a test signal (30) to the switching elements (12a, 12b),
wherein, when the switching elements (12a, 12b) are closed, i.e. conductive, the test signal is transmitted to the signal changing elements (40a, 40b),
wherein the test signal (30) is changed by a first and second signal changing element (40a, 40b) in different ways in each case and a first and second check signal (44a, 44b) are generated by the change, wherein a signal receiver receives the first and/or second check signal (44a, 44b), and wherein the first signal changing element (40a) generates the first check signal (44a) from the test signal (30) by a first phase shift
and
the second signal changing element (40b) generates the second check signal (44b) from the test signal (30) by a second phase shift which is different from the first phase shift.

## Revendications

1. Dispositif de commutation (10) pour des applications de sécurité, qui est conçu pour commuter une charge électrique (18),
**caractérisé en ce que**
le dispositif de commutation (10) comprend au moins deux éléments de commutation (12a, 12b) montés en série et présente en outre un organe de vérification (24) qui surveille l'état de commutation réel des éléments de commutation (12a, 12b),
l'organe de vérification (24) comprend un générateur de signal pour délivrer un signal de test (30) aux éléments de commutation (12a, 12b),
l'organe de vérification comprend un premier élément de modification de signal (40a) couplé électriquement au premier élément de commutation (12a), et un deuxième élément de modification de signal (40b) couplé électriquement au deuxième élément de commutation (12b),
lorsque les éléments de commutation (12a, 12b) sont fermés, c'est-à-dire conducteurs, le signal de test est transmis aux éléments de modification de signal (40a, 40b),
les premier et deuxième éléments de modification de signal (40a, 40b) modifient un signal de test (30) entrant respectif de différentes manières et génèrent des premier et deuxième signaux de contrôle (44a, 44b) en raison de la modification, un récepteur de signal recevant le premier et/ou le deuxième signal de contrôle (44a, 44b), et
le premier élément de modification de signal (40a) génère le premier signal de contrôle (44a) à partir du signal de test (30) par un premier déphasage,
et
le deuxième élément de modification de signal (40b) génère le deuxième signal de contrôle (44b) à partir du signal de test (30) par un deuxième déphasage qui diffère du premier déphasage.

2. Dispositif de commutation (10) selon la revendication 1,
dans lequel le signal de test (30) et le premier signal de contrôle (44a) et/ou le signal de test (30) et le deuxième signal de contrôle (44b) sont amenés chacun à une porte OU exclusif, XOR, afin de déterminer un déphasage entre le signal de test (30) et le premier et/ou le deuxième signal de contrôle (40a, 40b).

3. Dispositif de commutation (10) selon l'une des revendications précédentes, dans lequel le signal de test (30) est amené aussi bien au premier qu'au deuxième élément de commutation (12a, 12b), le signal de test (30) étant transmis du premier élément de commutation (12a) au premier élément de modification de signal (40a) et/ou du deuxième élément de commutation (12b) au deuxième élément de modification de signal (40b) lorsque l'élément de commutation respectif (12a, 12b) est conducteur.

4. Dispositif de commutation (10) selon l'une des revendications précédentes, dans lequel le signal de test (30) comprend une composante sinusoïdale qui présente de préférence une fréquence supérieure à 50 kHz, en particulier une fréquence comprise entre 50 et 300 kHz.

5. Dispositif de commutation (10) selon la revendication 4,
dans lequel la composante sinusoïdale présente une fréquence comprise entre 50 et 300 kHz.

6. Dispositif de commutation (10) selon l'une des revendications précédentes, dans lequel le générateur de signal et/ou le récepteur de signal présente(nt) le même microcontrôleur (24).

7. Dispositif de commutation (10) selon l'une des revendications précédentes, dans lequel le générateur de signal et/ou le récepteur de signal sont (chacun) reliés électriquement aux éléments de commutation (12a, 12b) au moyen d'un condensateur de couplage (34, 38) afin d'assurer une isolation capacitive.

8. Dispositif de commutation (10) selon l'une des revendications précédentes, dans lequel le générateur de signal comprend un circuit oscillant (32), en particulier un circuit oscillant LC, et/ou un passe-bande (28).

9. Dispositif de commutation (10) selon la revendication 8,
dans lequel le circuit oscillant (32) comprend un circuit oscillant LC.

10. Dispositif de commutation (10) selon l'une des revendications précédentes, dans lequel l'organe de vérification (24) est conçu pour déterminer, au moins à partir du premier et/ou du deuxième signal de contrôle (44a, 44b), un temps de commutation nécessaire au premier et/ou au deuxième élément de commutation (12a, 12b) pour passer d'un état conducteur à un état non conducteur, ou inversement.

11. Dispositif de commutation (10) selon la revendication 10,
dans lequel l'organe de vérification (24) est conçu pour émettre un signal d'avertissement lorsque le temps de commutation dépasse une valeur seuil prédéterminée.

12. Dispositif de commutation (10) selon l'une des revendications précédentes, dans lequel les éléments de commutation (12a, 12b) sont découplés mécaniquement l'un de l'autre et ne sont en particulier pas soumis à un guidage forcé.

13. Dispositif de commutation (10) selon la revendication 12,
dans lequel les éléments de commutation (12a, 12b) ne sont pas soumis à un guidage forcé.

14. Dispositif de commutation (10) selon l'une des revendications précédentes, dans lequel le générateur de signal et/ou le récepteur de signal sont conçus de manière redondante.

15. Procédé de détection de l'état de commutation d'éléments de commutation (12a, 12b) dans un dispositif de commutation (10) pour des applications de sécurité, le dispositif de commutation (10) étant conçu pour commuter une charge électrique (18),
**caractérisé en ce que** le dispositif de commutation (10) comprend au moins deux éléments de commutation (12a, 12b) montés en série et présente en outre un organe de vérification, l'organe de vérification (24) délivrant un signal de test (30) aux éléments de commutation (12a, 12b),
lorsque les éléments de commutation (12a, 12b) sont fermés, c'est-à-dire conducteurs, le signal de test est transmis aux éléments de modification de signal (40a, 40b),
le signal de test (30) est modifié de différentes manières respectivement par un premier et un deuxième élément de modification de signal (40a, 40b), et des premier et deuxième signaux de contrôle (44a, 44b) sont générés en raison de la modification, un récepteur de signal recevant le premier et/ou le deuxième signal de contrôle (44a, 44b), et
le premier élément de modification de signal (40a) génère le premier signal de contrôle (44a) à partir du signal de test (30) par un premier déphasage,
et
le deuxième élément de modification de signal (40b) génère le deuxième signal de contrôle (44b) à partir du signal de test (30) par un deuxième déphasage qui diffère du premier déphasage.
